Europäisches Patentamt

European Patent Office

Office européen des brevets

(19)

(11) Publication number: **0 451 855 A1**

# EUROPEAN PATENT APPLICATION

(21) Application number: 91105832.9

(22) Date of filing: **12.04.91**

(51) Int. Cl.⁵: **H01L 21/302**, H01L 21/322, H01L 21/205

(30) Priority: **12.04.90 JP 97219/90**

(43) Date of publication of application:
**16.10.91 Bulletin 91/42**

(84) Designated Contracting States:
**DE FR GB**

(71) Applicant: **Kabushiki Kaisha Toshiba**
**72, Horikawa-cho Saiwai-ku**
**Kawasaki-shi(JP)**

(72) Inventor: **Kotani, Shigeo**
**K-1-4-2, Shoman Life Town, 3215, Ooba**
**Fujisawa-shi, Kanagawa-ken(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) Method of manufacturing an epitaxial wafer.

(57) There is disclosed a method of manufacturing an epitaxial wafer which has the steps of: slicing a silicon single crystal pulled up to provide a wafer; etching the principal surface of the wafer to remove a damaged layer due to slicing of the surface; implementing specular processing to the principal surface of the wafer, allowing silicon to be subjected to vapor-phase epitaxial growth on the specularly processed principal surface; and implementing specular processing to the principal surface for a second time to remove various defects produced at the time of vapor-phase epitaxial growth, thus to improve flatness. By specularly processing the wafer surface after epitaxial growth, dust source and defect such as crown, etc. causing lowering of flatness, produced at the time of epitaxial growth, can be removed.

FIG. 1

EP 0 451 855 A1

## BACKGROUND OF THE INVENTION

This invention relates to a method of manufacturing an epitaxial wafer, and more particularly to an epitaxial wafer manufacturing method most suitable for highly integrated devices such as 1M, 4M, or 16M bit devices, etc.

A semiconductor device is formed on a wafer provided by slicing a silicon single crystal obtained by a pulling method. The following method is a known method relatively frequently used. Namely, an external shape processing is implemented to a CZ crystal formed by pulling using the Czochralski method so that it is in the form of an accurate cylinder, and is then sliced. Thereafter, etching is implemented in order to remove a damaged layer formed on the surface by machining at the time of slicing. Further, an abrasive process for improvement of flatness or planarization, removal of surface defects, and improvement of surface roughness is implemented.

However, in such a silicon single crystal, there exists a large number of, e.g., 14 to 18 x $10^{17}$ precipitated oxygen nuclei per centimeter prepared by oxygen admitted from a quartz crucible at the process of melting silicon. These precipitated oxygen nuclei may become crystal defects by the thermal processing or the process pollution at the device manufacturing process, leading to leak or unsatisfactory withstand voltage in the case of microelements. To solve this, an attempt is made to apply processed distortions to the back surface of the wafer to provide gettering nuclei for adsorbing oxygen, to thereby carry out cleaning of the principal surface. Namely, micro-defects are given to the crystal by implementing mechanical abrasion to the back surface of the wafer, or spraying, at a high pressure, silicon oxide powder or diffusion liquid into water, to thus form gettering nuclei for capturing polluted atoms. This method is certainly effective, but the mechanically processed layer results in a cause of dust. Accordingly, from a microscopic point of view, dust may be produced on the principal surface of the wafer. In this sense, this method is not necessarily satisfactory.

For this reason, there has been developed an epitaxial wafer in which an epitaxial layer hardly including oxygen is formed on the surface layer where devices are to be formed.

However, even if an initial material of excellent cleanness and flatness is used, conventional epitaxial wafers are not sufficient with respect to dust.

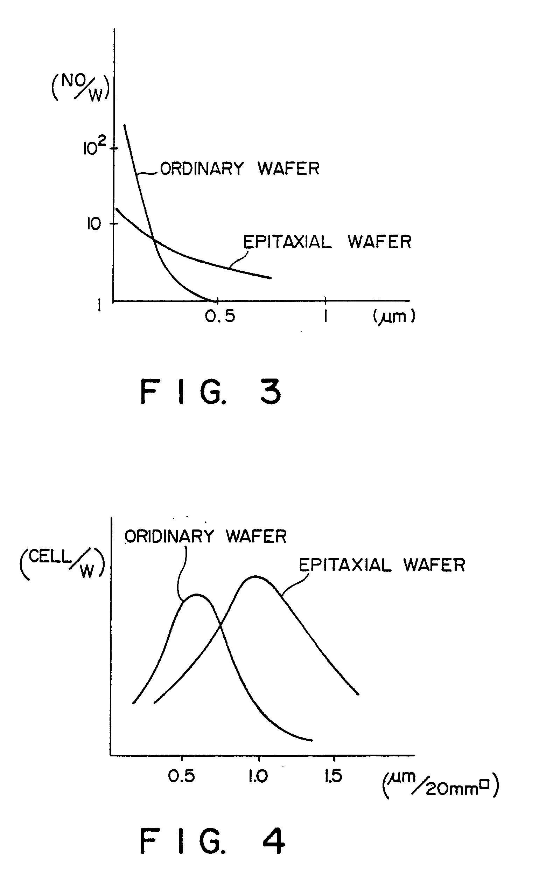

FIG. 3 is a graph showing, in a comparative manner, what sizes of dust are observed in the case of an ordinary wafer having a diameter of 150 mm and in the case where an epitaxial layer is formed on the ordinary wafer.

In accordance with this figure, in the case of the ordinary wafer, a large number of small dust are observed, whereas, in the case of the epitaxial wafer, not only small dust but also relatively large dust are observed. With respect to dust of, e.g., 0.3 $\mu$m or more, the number of such dust is about 1 to 2 per each wafer on the conventional wafer, whereas the number thereof is increased to about 3 to 5 after epitaxially grown. Dust of a size of about 0.1 $\mu$m observed in the case of the conventional wafer is an adsorber including water molecule as the major component. Since such an adsorber vanishes in the atmosphere of high temperature hydrogen for epitaxial growth, it is considered that this absorber does no actual harm. However, dust of a large size exerts an influence on the yield of the device. To prevent the occurrence of dust, cleaning within the crystal growth device and/or mechanization or skillfulness of handling of the wafer are implemented in order to minimize the damage of the epitaxial process. However, such a measure is not sufficient. It is to be noted that a yield loss amounting to 70% is produced if an attempt is made to provide an epitaxial wafer having the same quality as the specularly processed wafer before epitaxial growth.

The comparison between the flatness of the conventional wafer and that of the epitaxial wafer is shown in FIG. 4. This figure shows the distribution of an uneveness difference in the cell with 20 mm□ as a unit. By the epitaxial growth, the peak value of the unevenness difference is deteriorated by 0.2 to 0.5 $\mu$m. Such a deterioration is considered to be caused by unevenness of the thickness of the film grown at the time of vapor phase growth, and partial growth of silicon due to flowing to the back surface of the wafer of reaction gas.

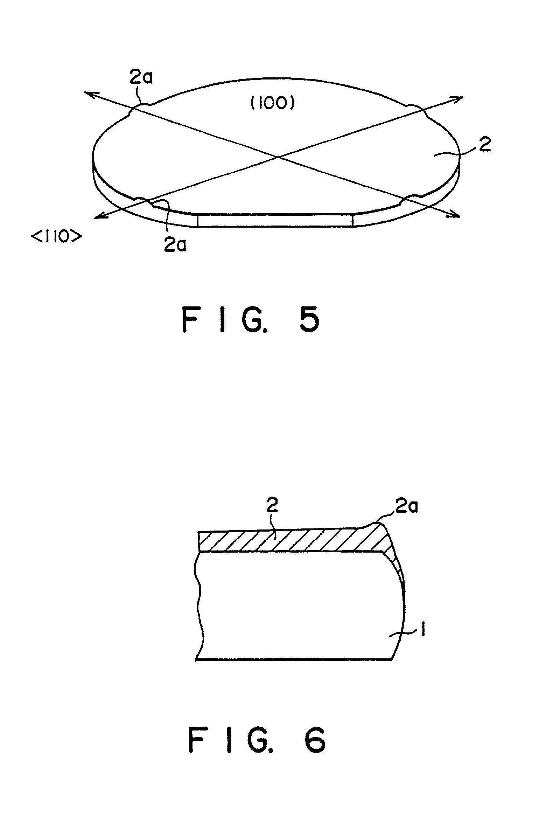

Occasionally, as shown in FIG. 5, there is an extraordinary growth occuring frequently caused by growth facet at four points in the crystal orientation ⟨110⟩ direction at the peripheral edge portion of the (100) plane of the wafer 1. This extraordinary growth is called a crown.

FIG. 6 is a partial cross sectional view taken along the ⟨100⟩ direction of the wafer. The shape of the crown is shown. It is seen from this figure that the upper end portion of the epitaxial growth layer 2 formed on the beveling processed wafer 1 is extraordinarily grown, resulting in the projection 2a. Such a crown not only damages flatness of the wafer, but also causes cracking due to impact of the mechanical processing at the time of handling or occurrence of silicon dust.

Further, deterioration of flatness or planarization allows the margin for focal depth at the exposure process for formation of circuit to be reduced. This exerts an adverse influence particularly on the dimensional accuracy of a fine pattern. Accordingly, the device function and/or yield may be lowered. For example, in the case of obtaining an epitaxial wafer of substantially the same flatness as 1 $\mu$m/20 mm from a material of flatness of about 1 $\mu$m/20 mm□, the yield loss amounts to 20%. The yield loss as a material for improving the flatness of a material so that it is equal to 0.5 to 0.7 $\mu$m/20 mm□ will reach 30 to 50 %.

Furthermore, when the wafer to which the processing for forming getter is implemented is epitaxially grown, the distortion formed at a high temperature ranging from 1150 to 1250°C at this process are annealed, or the density is reduced by growth of the epitaxial layer on the back surface of the wafer, resulting in a considerably lowered gettering effect.

Accordingly, an object of this invention is to provide a method of manufacturing an epitaxial wafer for high integration devices having fewer surface defects and excellent planarization characteristics.

## SUMMARY OF THE INVENTION

In one aspect, a method of manufacturing an epitaxial wafer according to this invention comprises the steps of slicing a silicon single crystal pulled up to provide a wafer, etching the principal surface of the wafer to remove a damaged layer due to slicing of the surface, implementing specular processing to the principal surface, allowing silicon to be subjected to vapor-phase epitaxial growth on the specularly processed principal surface, and implementing specular processing to the principal surface for a second time to remove various defects produced at the time of the vapor phase epitaxial growth to improve flatness.

In another aspect, a method of manufacturing an epitaxial wafer according to this invention comprises the steps of slicing a silicon single crystal pulled up to provide a wafer, etching the principal surface of the wafer to remove a damaged layer due to slicing of the surface, allowing silicon to be subjected to vapor-phase epitaxial growth on the etched principal surface, and implementing specular processing to the principal surface on which the vapor-phase epitaxial growth is carried out to remove various defects produced at the time of the vapor-phase epitaxial growth to improve flatness.

Between the vapor-phase epitaxial growth step and the specular processing step, it is preferable to provide, in an arbitrary order, a beveling processing step for removing an extraordinary growth layer produced at the time of the silicon epitaxial growth at the peripheral edge portion of the wafer, and a step for forming backside damage of the wafer.

In accordance with this invention, since specular processing is implemented to the wafer surface after epitaxial growth, it is possible to remove dust sources and/or defects such as crown, etc. causing lowering of flatness, which are produced by the epitaxial growth, to thus prevent the occurrence of dust, and to attain a desired planarization. Thus, the device quality and the yield can be improved.

In addition, when an approach is employed to carry out the epitaxial growth after etching, it is sufficient to implement only one process for the epitaxial growth and the specular processing. Thus, the total process can be simplified.

## BRIEF DESCRIPTION OF THE DRAWINGS

In the accompanying drawings:

FIG. 1 is a flowchart showing a first embodiment of a process for manufacturing an epitaxial wafer according to this invention,

FIG. 2 is a flowchart showing a second embodiment of a process for manufacturing an epitaxial wafer according to this invention,

FIG. 3 is a graph showing, in a comparative manner, the distributions of dust in the cases of an ordinary wafer and a wafer on which an epitaxial layer is formed,

FIG. 4 is a graph showing a comparison between flatness of an ordinary wafer and that of an epitaxial wafer,

FIG. 5 is a perspective view showing how crown is produced, and

FIG. 6 is a cross sectional view showing the crown in detail.

## DESCRIPTION OF THE PREFERRED EMBODIMENTS

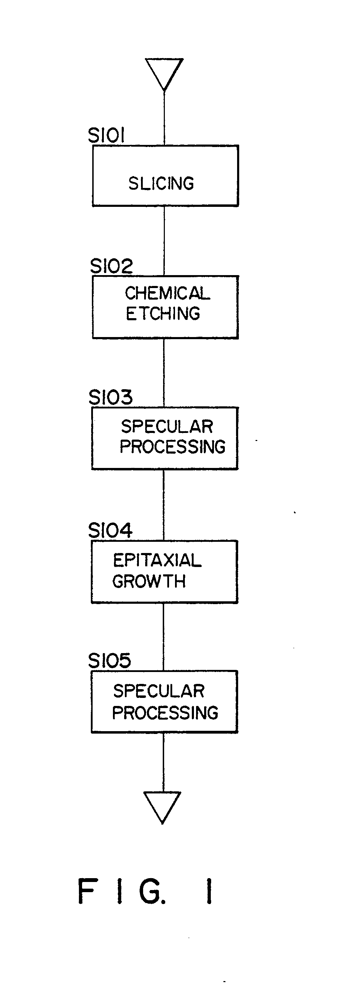

FIG. 1 is a flowchart showing a first embodiment of a method of manufacturing an epitaxial wafer according to this invention.

Initially, a silicon single crystal to which external shape processing is implemented is sliced (step S101). The silicon single crystal thus sliced is chemically etched to remove a damaged layer produced at the time of slicing (step S102). Then, specular processing is implemented to the surface by chemical abrasion (step S103). The planarization of the surface is considerably improved by this specular processing.

A silicon layer is then formed by epitaxial growth (step S104). In the case of manufacturing an epitaxial wafer for MOS IC, a wafer is heated at about 1150°C in the atmosphere of hydrogen to introduce a mixture of silicon compound and carrier gas to form decomposed silicon atoms as a single crystal layer 10 to 20 $\mu$m thick on a silicon substrate. In this example, a silicon compound, silicon tetrachloride ($SiH_4$), trichlorosilane ($SiHCl_3$), or dichlorosilane ($SiH_2Cl_2$), etc. may be used.

Finally, specular processing by chemical abrasive process is carried out for a second time (step S105). This second specular processing is carried out in order to remove dust and crown causing deterioration of flatness, which are produced in the epitaxial growth, and attached dust.

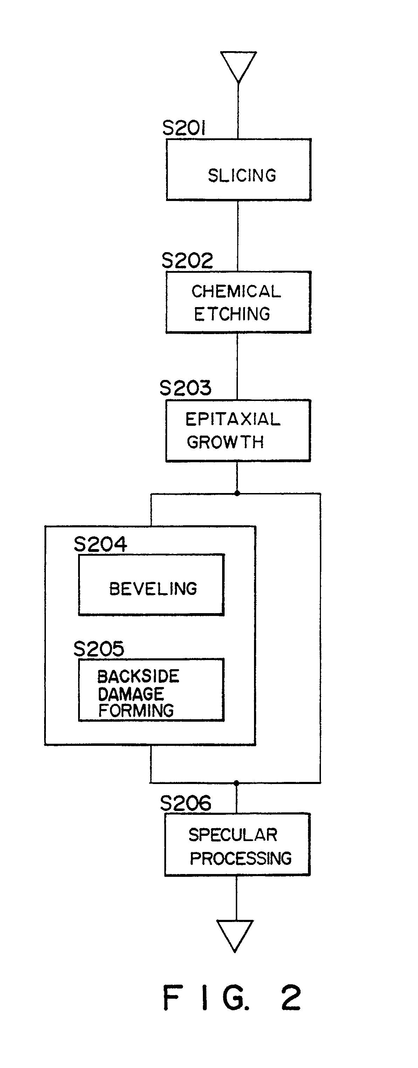

FIG. 2 is a flowchart showing a second embodiment of a method of manufacturing an epitaxial wafer according to this invention.

Initially, a silicon single crystal to which external processing is implemented is sliced (step S201). The silicon single crystal thus sliced is chemically etched to remove a damaged layer produced at the time of slicing. A silicon layer is then formed by vapor-phase epitaxial growth on the etched surface (step S203). The epitaxial growth condition is the same as that in the case of FIG. 1.

Beveling processing for removing the peripheral edge portion of the upper surface of the wafer is then carried out (step S204). As previously described, growth of the ⟨100⟩ orientation is fast at the time of vapor-phase growth of silicon, so crown is apt to take place on the (110) plane. The above-mentioned beveling processing is implemented in order to remove such a crown.

Honing processing for forming processed distortions having gettering effect is implemented to the back surface of the wafer after vapor-phase epitaxial growth (step S205). While this processed distortion formation process may be added also before the vapor-phase epitaxial growth process, since distortion may be reduced at the vapor-phase epitaxial growth process as previously described, it is desirable to newly add such processed distortion formation process. Steps S204 and S205 are addition processes for improving the characteristic of the wafer.

Finally, specular processing by chemical abrasion is carried out for a second time (step S206). This specular processing is carried out in order to remove defects produced at the epitaxial growth process step and process steps succeeding thereto to improve flatness.

In this embodiment, since an epitaxial layer is directly formed on the chemical etching surface, the boundary between the silicon base layer and the epitaxial growth layer has a degree of unevenness greater than that of the specular surface of the wafer surface from a microscopic point of view. However, the adverse influence on the electric characteristic was not particularly observed in devices using only a surface area as an active area as in MOS device.

In the flowchart of FIG. 2, the beveling processing and the honing processing may be carried out in reverse order. Further, without carrying out these processing, the method of this invention may be implemented so as to immediately shift from the vapor-phase epitaxial growth process step to the specular processing step.

In addition, since specular processing may carried out after epitaxial growth in the above-mentioned any process steps, dust source such as crown, etc. and the cause to lower the flatness produced at the time of epitaxial growth can be removed.

**Claims**

1. A method of manufacturing an epitaxial wafer comprising the steps of:
   slicing a silicon single crystal pulled up to provide a wafer,
   etching the principal surface of said wafer to remove a damaged layer due to slicing of the wafer surface,
   implementing specular processing to said principal surface,
   allowing silicon to be subjected to vapor-phase epitaxial growth on said specularly processed principal surface, and
   implementing specular processing to said principal surface for a second time to remove various defects produced at the time of said vapor-phase epitaxial growth, to thus improve flatness.

2. A method of manufacturing an epitaxial wafer comprising the steps of:
   slicing a silicon single crystal pulled up to provide a wafer,
   etching the principal surface of said wafer to remove a damaged layer due to slicing of the wafer surface,
   allowing silicon to be subjected to vapor-phase epitaxial growth on said etched principal surface, and
   implementing specular processing to said principal surface on which the vapor-phase epitaxial growth is carried out to remove various defects produced at the time of said vapor-phase epitaxial growth, to thus improve flatness.

3. A method of manufacturing an epitaxial wafer as set forth in claim 2, wherein a beveling processing process step for removing an extraordinary growth layer produced at the time of silicon vapor-phase epitaxial growth at the wafer peripheral edge portion, and a processing process for forming backside damage of said wafer are provided in an arbitrary order between said vapor-phase epitaxial growth process step and said specular processing process step.

SIOI
```
┌─────────────┐
│   SLICING   │
└─────────────┘
```

SIO2
```
┌─────────────┐
│  CHEMICAL   │
│  ETCHING    │
└─────────────┘
```

SIO3
```
┌─────────────┐
│  SPECULAR   │
│ PROCESSING  │
└─────────────┘
```

SIO4
```
┌─────────────┐
│  EPITAXIAL  │
│   GROWTH    │
└─────────────┘
```

SIO5
```
┌─────────────┐
│  SPECULAR   │
│ PROCESSING  │
└─────────────┘
```

# F I G.  I

S201 | SLICING

S202 | CHEMICAL ETCHING

S203 | EPITAXIAL GROWTH

S204 | BEVELING

S205 | BACKSIDE DAMAGE FORMING

S206 | SPECULAR PROCESSING

F I G. 2

F I G. 3

F I G. 4

F I G. 5

F I G. 6

European
Patent Office

**EUROPEAN SEARCH
REPORT**

Application Number

**EP 91 10 5832**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | US-A-4 885 056 (JAMES B. HALL ET AL.)<br>* column 2, line 17 - column 3, line 4 *<br>– – – | 1,2 | H 01 L 21/302<br>H 01 L 21/322<br>H 01 L 21/205 |
| Y | PATENT ABSTRACTS OF JAPAN vol. 9, no. 315 (E-365) 11 December 1985,<br>& JP-A-60 148137 (NIPPON DENKI K.K.) 05 August 1985,<br>* the whole document *<br>– – – | 1,2 | |
| A | EP-A-0 319 805 (K.K. TOSHIBA)<br>* column 3, lines 33 - 46; figure 1 * * column 8, line 58 - column 9, line 19; claims 1, 2, 4, 5; figure 13 *<br>– – – | 1-3 | |
| A | GB-A-2 014 790 (HITACHI LTD.)<br>* page 2, lines 7 - 65; claims 9, 12, 13, 15; figures 1, 3 *<br>– – – | 2,3 | |
| A | PATENT ABSTRACTS OF JAPAN vol. 4, no. 175 (E-036) 03 December 1980,<br>& JP-A-55 121644 (CHIYOU LSI GIJUTSU KENKYU KUMIAI) 18 September 1980,<br>* the whole document *<br>– – – | 1,2 | |
| A | RESEARCH DISCLOSURE. no. 271, November 1986, HAVANT GB page 671 "Method for very flat wafer polishing"<br>* page 671, right-hand column *<br>– – – – – | 1 | **TECHNICAL FIELDS SEARCHED (Int. Cl.5)**<br><br>H 01 L<br>C 30 B<br>C 23 C |

The present search report has been drawn up for all claims

| Place of search | Date of completion of search | Examiner |
|---|---|---|
| Berlin | 19 June 91 | KLOPFENSTEIN P R |